# EUROPEAN PATENT APPLICATION

(11) **EP 4 712 724 A1**
(43) Date of publication of application: **18.03.2026**
(21) Application number: 25200777.8
(22) Date of filing: 08.09.2025
(51) Int. Cl.: H10D 30/65, H10D 62/17, H10D 64/00, H10D 64/23, H10D 64/27, H10D 62/10, H10D 62/13

(54) **LDMOS TRANSISTOR**

(30) Priority: 14.09.2024 CN 202411297296
(71) Applicant: Silergy Semiconductor Technology (Hangzhou) Ltd, Hangzhou City, Zhejiang 310051 (CN)
(72) Inventor: YU, Hui, Hangzhou City, Zhejiang Province, 310051 (CN); CAI, Jun, Hangzhou City, Zhejiang Province, 310051 (CN)
(74) Representative: Viering, Jentschura & Partner mbB Patent- und Rechtsanwälte

(57) **Abstract**

An LDMOS transistor, comprising: a semiconductor region; a body region of a second doping type extending from an upper surface of the semiconductor region to an interior of the semiconductor region; a source region of a first doping type and a body contact region of the second doping type extending from an upper surface of the body region to an interior of the body region; a drain region of the first doping type located in the semiconductor region; and a source electrode being in contact with the body contact region and the source region; wherein a junction depth of the body contact region is greater than a junction depth of the source region, so as to reduce the base resistance of a surface parasitic transistor, thereby reducing the influence of the parasitic transistor on the robustness of the LDMOS transistor.

## Description

### FIELD OF THE INVENTION

The present disclosure relates to the field of semiconductor technology, and in particular to an LDMOS transistor.

### BACKGROUND OF THE INVENTION

Laterally diffused metal oxide semiconductor (LDMOS) transistors, known for their high breakdown voltage and compatibility with complementary metal oxide semiconductor (CMOS) processes, are widely used as power devices in power integrated circuits. However, with the increase in integration density and the reduction of process linewidth, the turn-on of parasitic transistors within the LDMOS has become important mechanism for a device failure, greatly reducing the reliability of the device.

### SUMMARY OF THE INVENTION

The present disclosure provides an LDMOS transistor, solving the above-mentioned problems.

According to a first aspect of the present disclosure, an LDMOS transistor is provided, comprising: a semiconductor region; a body region of a second doping type extending from an upper surface of the semiconductor region to an interior of the semiconductor region; a source region of a first doping type and a body contact region of the second doping type extending from an upper surface of the body region to an interior of the body region; a drain region of the first doping type located in the semiconductor region; and a source electrode being in contact with the body contact region and the source region; wherein a junction depth of the body contact region is greater than a junction depth of the source region.

Preferably, the body contact region surrounds at least a portion of a lower surface of the source region.

Preferably, the source electrode is located on upper surfaces of the source region and the body contact region.

Preferably, the source electrode extends from an upper surface of the body contact region to an interior of the body contact region.

Preferably, the source electrode extends to a depth in the body contact region that is greater than the junction depth of the source region.

Preferably, the source electrode is in contact with a side surface of the source region.

Preferably, the source electrode comprises a trench located in the body contact region and a conductive material located in the trench.

Preferably, a width of the body contact region along a direction from the source region to the drain region is greater than a width of the source electrode.

Preferably, the LDMOS transistor further comprises: a gate dielectric layer adjacent to the source region, located on the upper surface of the semiconductor region; and a voltage-blocking layer adjacent to the drain region, located on the semiconductor region.

Preferably, the LDMOS transistor further comprises: a buffer field plate disposed between the gate dielectric layer and the voltage-blocking layer and located on the upper surface of the semiconductor region, wherein a thickness of the voltage-blocking layer is greater than a thickness of the buffer field plate, and the thickness of the buffer field plate is greater than a thickness of the gate dielectric layer.

Preferably, the LDMOS transistor further comprises a drift region of the first doping type located in the semiconductor region, wherein the drift region is located below at least the voltage-blocking layer.

Preferably, the voltage-blocking layer protrudes toward the interior of the semiconductor region.

Preferably, a lower surface of the buffer field plate and a lower surface of the gate dielectric layer are located on a same plane parallel to a direction from the source region to the drain region.

Preferably, a lower surface of the buffer field plate and a lower surface of the gate dielectric layer are higher than a lower surface of the voltage-blocking layer

Preferably, the thickness of the gate dielectric layer is set to be in a range of 0.95 nm-9.5 nm.

### BRIEF DESCRIPTION OF DRAWINGS

The above and other purposes, features and advantages of the present disclosure will become more apparent through the following description of the embodiments of the present disclosure with reference to the accompanying drawings, wherein:
FIG. 1 is a cross-sectional view of an LDMOS transistor according to a first embodiment of the present disclosure;
FIG. 2 is a cross-sectional view of an LDMOS transistor according to a second embodiment of the present disclosure;
FIG. 3 is a cross-sectional view of an LDMOS transistor according to a third embodiment of the present disclosure;
FIG. 4 is a cross-sectional view of an LDMOS transistor according to a fourth embodiment of the present disclosure;
FIG. 5 is a cross-sectional view of an LDMOS transistor according to a fifth embodiment of the present disclosure;
FIG. 6 is a cross-sectional view of an LDMOS transistor according to a sixth embodiment of the present disclosure.

### DETAILED DESCRIPTION

The present disclosure will be described in more detail below with reference to the accompanying drawings. In each of the accompanying drawings, the same elements are represented by similar reference numerals. For the sake of clarity, the various parts in the accompanying drawings are not drawn to scale. In addition, some known parts may not be shown. For the sake of simplicity, the semiconductor structure obtained after several steps can be described in one figure.

It should be understood that in case of describing the structure of a device, when a layer or a region is referred to as being "on" or "over" another layer or another region, it may mean that it is directly on another layer or another region, or that other layers or regions are included between it and another layer or another region. Furthermore, if the device is turned over, the layer or the region will be "below" or "beneath" another layer or another region.

If it is to describe the situation of being directly located on another layer or another region, the expression "A is directly located on B" or "A is located on B and adjacent to it" will be used in this article. In the present application, "A is directly located in B" means that A is located in B and A is directly adjacent to B, rather than A being located in a doped region formed in B.

Many specific details of the present disclosure are described below, such as device structures, materials, dimensions, and processing technology and techniques, so as to more clearly understand the present disclosure. However, as those skilled in the art understand, the present disclosure may be implemented without following these specific details.

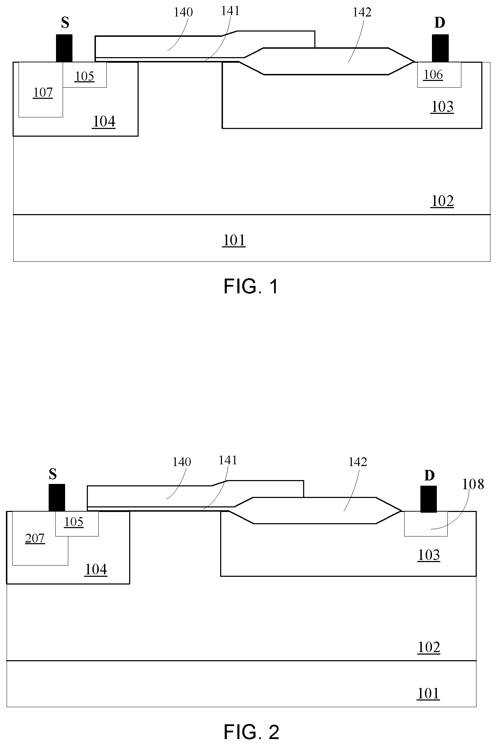

FIG. 1 is a cross-sectional view of an LDMOS transistor according to a first embodiment of the present disclosure. As shown in FIG. 1, the LDMOS transistor includes: a semiconductor region 102; a body region 104 of a second doping type extending from an upper surface of the semiconductor region 102 to an interior of the semiconductor region; a source region 105 of a first doping type and a body contact region 107 of the second doping type extending from an upper surface of the body region 104 to an interior thereof; a drain region 106 of the first doping type located in the semiconductor region 102; and a source electrode S being in contact with the body contact region 107 and the source region 105 and located on upper surfaces of the body contact region 107 and the source region 105; wherein a junction depth of the body contact region 107 is greater than a junction depth of the source region 105. As an example, the body contact region 107 is in contact with a side surface of the source region 105. Alternatively, as shown in FIG. 2, the body contact region 207 surrounds at least a portion of a lower surface of the source region 105. Optionally, the body contact region 207 may also surround the entire lower surface of the source region 105.

The LDMOS transistor further includes a drift region 103 of the first doping type; a gate dielectric layer 141 adjacent to the source region 105, located on the upper surface of the semiconductor region 102; a voltage-blocking layer 142 adjacent to the drain region 106, located on the semiconductor region 102; and a gate conductor 140 located on at least the gate dielectric layer. As an example, the body region 104 extends to a bottom of a portion of the gate dielectric layer 141, the drift region 103 at least extends to a bottom of the voltage-blocking layer 142, the drain region 106 is located in the drift region 103 and on a side of the voltage-blocking layer 142 away from the gate dielectric layer 141, and the gate conductor 140 further extends to the voltage-blocking layer 142.

As an example, the L DMOS transistor further includes a substrate 101. The substrate is of the second doping type, and the semiconductor region is of the first doping type. Alternatively, the semiconductor region may also be of the second doping type, in which case, the body region and the drift region need to be arranged in contact. In addition, an epitaxial layer or a buried layer may also be included between the substrate and the semiconductor region.

The base resistance of the parasitic transistor (source region 105/body region 104/semiconductor region 102 and drift region 103) is reduced by setting the junction depth of the body contact region to be greater than the junction depth of the source region, thereby reducing the influence of the parasitic transistor on the robustness of the LDMOS transistor.

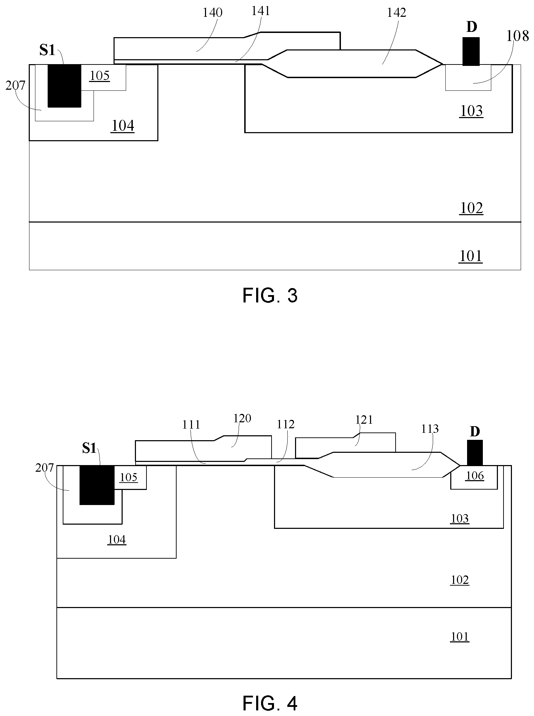

FIG. 3 is a cross-sectional view of an LDMOS transistor according to a third embodiment of the present disclosure. The difference between the LDMOS transistor shown in FIG. 3 and the LDMOS transistor shown in FIG. 2 is that the body contact region and the source electrode are arranged differently. Other structures are substantially the same.

As shown in FIG. 3, the body contact region 207 extends from the upper surface of the body region 104 to an interior of the body region 104, and the body contact region 207 extends laterally to a bottom of the source region 105 to partially surround the lower surface of the source region 105. The source electrode S1 extends from the upper surface of the body contact region 207 to the interior thereof, and the source electrode S1 is in contact with a side surface of the source region 105. Furthermore, the lower surface of the source electrode S1 is lower than the lower surface of the source region 105, and a width of the source electrode S1 along a direction from the source region to the drain region is less than a width of the body contact region 207. Specifically, the source electrode S1 includes a trench located in the body contact region 207, and a conductive material filled in the trench.

The setting of the body contact region and the source electrode in the present disclosure makes it easier for the accumulated charge in the base region of the surface parasitic transistor to be drawn away by the source electrode in the body contact region, which is beneficial to improving the high current capability and robustness of the LDMOS transistor and enhancing the reverse recovery capability of the transistor.

FIG. 4 is a cross-sectional view of an LDMOS transistor according to a fourth embodiment of the present disclosure. The difference between the LDMOS transistor shown in FIG. 4 and the LDMOS transistor shown in FIG. 3 is that, in FIG. 4 the LDMOS transistor further includes a buffer field plate 112. As shown in FIG. 4, the LDMOS transistor includes: the semiconductor region 102; the source region 105 of the first doping type and the drain region 106 of the first doping type located in the semiconductor region 102; a gate dielectric layer 111 adjacent to the source region 105, located on the upper surface of the semiconductor region 102; a voltageblockinglayer 113 adjacent to the drain region, located on the upper surface of the semiconductor region and protruding toward the interior of the semiconductor region 102, and a buffer field plate 112 disposed between the gate dielectric layer 111 and the voltage-blocking layer 113 and located on the upper surface of the semiconductor region 102, wherein a thickness of the voltage-blocking layer 113 is greater than the thickness of the buffer field plate 112, and the thickness of the buffer field plate 112 is greater than a thickness of the gate dielectric layer 111. Preferably, a length of the gate dielectric layer 111 is less than a length of the voltageblockinglayer 113; a length of the buffer field plate 112 is less than the length of the voltage-blocking layer 113. It should be noted that the length and the thickness of the buffer field plate 112 and the length and the thickness of the voltage-blocking layer 113 can be adjusted according to the requirements of an applied voltage and ultimate optimization of specific on-resistance Rsp.

As an example, a lower surface of the voltage-blocking layer 113 is lower than a lower surface of the buffer field plate 112, an upper surface of the buffer field plate 112 is higher than an upper surface of the gate dielectric layer 111, and an upper surface of the voltage-blocking layer 113 is higher than the upper surface of the buffer field plate 112. The lower surface of the buffer field plate 112 and the lower surface of the gate dielectric layer 111 are coplanar or substantially coplanar. It should be noted that when the gate dielectric layer 111 and the buffer field plate 112 are both formed by depositing a dielectric layer, the lower surface of the buffer field plate 112 and the lower surface of the gate dielectric layer 111 are located on the same plane; when the gate dielectric layer 111 and the buffer field plate 112 are both formed by thermal oxidation growth, the lower surface of the buffer field plate 112 may be slightly lower than the lower surface of the gate dielectric layer 111.

As an example, the buffer field plate 112 have a uniform thickness. Optionally, the buffer field plate is arranged along the direction from the source region to the drain region, and the thickness of the buffer field plate increases gradually.

As an example, the voltage-blocking layer 113 is configured to be shaped like a bird's beak and is formed by a local oxidation of silicon process. The thickness of the voltage-blocking layer 113 is uniform except for the bird's beak portion. Alternatively, the voltage-blocking layer 113 may also be formed by a process of depositing a dielectric layer. In this case, the lower surface of the voltage-blocking layer 113 and the lower surface of the buffer field plate 112 are substantially coplanar. Optionally, the thickness of the voltage-blocking layer 113 increases along the direction from the source region to the drain region.

As an example, the thickness of the gate dielectric layer is set to be in a range of 0.95 nm-9.5 nm, which allows the gate dielectric layer to be formed synchronously with gate oxide of a CMOS device. The thickness of the buffer field plate is set to be in a range of 4 nm-40 nm, and the thickness of the voltage-blocking layer is set to be in a range of 25 nm-350 nm. Both the buffer field plate and the voltage-blocking layer can be formed by the thermal oxidation growth process or the deposition process.

The LDMOS transistor further includes a gate conductor 120 and a field shielding conductor 121 which are separately arranged, wherein the gate conductor 120 is at least located on the gate dielectric layer 111, and the field shielding conductor 121 is at least located on the voltage-blocking layer 113. As an example, the gate conductor 120 is located on the gate dielectric layer 111 and a portion of the buffer field plate 112, and the field shielding conductor 121 is located on a portion of the voltage-blocking layer 113 and a portion of the buffer field plate 112. Optionally, the gate conductor 120 is only located on the gate dielectric layer 111, or may extend from the gate dielectric layer 111 to the buffer field plate 112, or may extend from the gate dielectric layer 111 to the voltage-blocking layer 113; the field shielding conductor 121 may be only located on the voltage-blocking layer 113, or may extend from the voltage-blocking layer 113 to the buffer field plate 112. The gate conductor 120 and the field shielding conductor 121 are preferably made of a polysilicon material. The field shielding conductor may be set to the first doping type or the second doping type. The field shielding conductor 121 may be connected to the same potential as the gate conductor 120, or the field shielding conductor 121 may be connected to other potentials separately.

The LDMOS transistor provided by the present application features an ultrathin gate dielectric layer 111, resulting in a low threshold voltage for the transistor, which reduces the energy required by low-threshold power modules in driving power integrated circuits and increases the switching frequencies of the low-threshold power modules. Moreover, the reduced threshold voltage increases the reverse surface channel current of the transistor, which in turn suppresses the body reverse recovery current flowing through the well and body regions. Consequently, the power loss in the power stage driver during high-frequency switching is significantly reduced, while the reverse recovery loss of the transistor is also minimized. The buffer field plate 112 can be regarded as an extension of the gate dielectric layer and has a thickness greater than that of the gate dielectric layer, thereby reducing the electric field intensity experienced by the gate dielectric layer near the drain region. This helps shorten the length of the gate dielectric layer, decrease the charge required to turn on the transistor, and suppress the tunneling current in the gate dielectric layer when the transistor operates under high voltage. In addition, the lower surface of the buffer field plate is coplanar with the lower surface of the gate dielectric layer, resulting in a shorter surface current path of the transistor, which can further reduce the transistor's specific on-resistance. The voltage-blocking layer 113 is formed as an oxide layer thicker than the buffer field plate 112 and protrudes inwardly into the semiconductor region, thereby lengthening the surface current path in the transistor's high-voltage region and enhancing its breakdown voltage capability. The voltage-blocking layer 113, together with the field shielding conductor located above it and electrically isolated from the gate electrode, as well as the drift region positioned below, cooperatively enhance the transistor's breakdown voltage, reduce voltage coupling from the drain to the gate stage, lower voltage coupling loss, and effectively decrease the transistor's specific on-resistance.

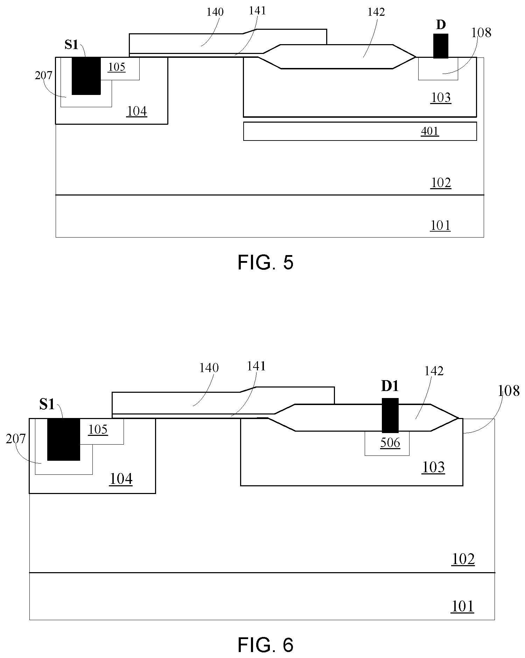

FIG. 5 is a cross-sectional view of an LDMOS transistor according to a fifth embodiment of the present disclosure. The difference between the LDMOS transistor shown in FIG. 5 and the LDMOS transistor shown in FIG. 3 is that the LDMOS transistor further includes a RESURF region of a second doping type. Other structures are substantially the same.

As an example, a RESURF region 401 of the second doping type is arranged below the drift region 103 of the first doping type to deplete each other with the drift region 103, reducing the surface electric field between the gate and drain of the transistor, and improve the breakdown voltage of the transistor. The RESURF region 401 may be configured to be in contact with the body region 104, or may be configured to be separated from the body region. A spacing between the drift region 103 and the RESURF region 401 is greater than or equal to 0. Alternatively, the drift region 103 and the RESURF region 401 may also be arranged left and right, or the RESURF region 401 surrounds the drift region 103, etc. The positional relationship between the drift region 103 and the RESURF region 401 may be adjusted as needed.

As an example, one drift region 103 and one RESURF region 401 are provided, respectively. Alternatively, a plurality of drift regions 103 and a plurality of RESURF regions 401 are provided.

Alternatively, the drift region 103 includes a plurality of first doped regions that are separately arranged, and the RESURF region 401 includes a plurality of second doped regions that are separately arranged. Specifically, the plurality of first doped regions that are separately arranged in a lateral direction, the plurality of second doped regions that are separately arranged in a lateral direction, and the second doped regions are located below the first doped regions. Preferably, one second doped region is arranged below each first doped region. A spacing between adjacent first doped regions and a width of each first doped region may be adjusted according to requirements, and a spacing between adjacent second doped regions and a width of each first doped region may also be adjusted according to requirements.

FIG. 6 is a cross-sectional view of an LDMOS transistor according to a sixth embodiment of the present disclosure. The difference between the LDMOS transistor shown in FIG. 6 and the LDMOS transistor shown in FIG. 3 is that the arrangements of the drain region are different. Other structures are substantially the same.

As an example, a drain region 506 is located below a voltage-blocking layer 143; a drain electrode D1 penetrates through the voltage-blocking layer 142 to be in contact with the drain region 506. Preferably, the drain region 506 is aligned with a side of the voltage-blocking layer 142 away from the gate dielectric layer 141. Optionally, the LDMOS transistor further includes a shallow isolation trench located below the voltage-blocking layer 142. The shallow isolation trench is disposed between the source region and the drain region.

As an example, the drain region is disposed below the voltage-blocking layer, and the formation of a metal silicide barrier layer in the drain region can be omitted, so as to reduce the size of the LDMOS transistor.

According to the embodiments of the present disclosure as described above, these embodiments do not describe all the details, nor do they limit the present disclosure to the specific embodiments described. Obviously, many modifications and changes can be made based on the above description. This specification selects and specifically describes these embodiments to better explain the principles and practical applications of the present disclosure, so that those skilled in the art can make good use of the present disclosure and the modified use based on the present disclosure. The present disclosure is limited only by the claims and their entire scope and equivalents.

## Claims

1. A laterally diffused metal oxide semiconductor (LDMOS) transistor, comprising:
a semiconductor region;
a body region of a second doping type, extending from an upper surface of the semiconductor region to an interior of the semiconductor region;
a source region of a first doping type and a body contact region of the second doping type, extending from an upper surface of the body region to an interior of the body region;
a drain region of the first doping type, located in the semiconductor region; and
a source electrode being in contact with the body contact region and the source region; wherein
a junction depth of the body contact region is greater than a junction depth of the source region.

2. The LDMOS transistor according to claim 1, wherein the body contact region surrounds at least a portion of a lower surface of the source region.

3. The LDMOS transistor according to claim 1, wherein the source electrode is located on upper surfaces of the source region and the body contact region.

4. The LDMOS transistor according to claim 1, wherein the source electrode extends from an upper surface of the body contact region to an interior of the body contact region.

5. The LDMOS transistor according to claim 4, wherein the source electrode extends to a depth in the body contact region that is greater than the junction depth of the source region.

6. The LDMOS transistor according to claim 4, wherein the source electrode is in contact with a side surface of the source region.

7. The LDMOS transistor according to claim 4, wherein the source electrode comprises a trench located in the body contact region and a conductive material filled in the trench.

8. The LDMOS transistor according to claim 4, wherein a width of the body contact region along a direction from the source region to the drain region is greater than a width of the source electrode.

9. The LDMOS transistor according to claim 1, further comprising:
a gate dielectric layer adjacent to the source region, located on the upper surface of the semiconductor region; and
a voltage-blocking layer adjacent to the drain region, located on the semiconductor region.

10. The LDMOS transistor according to claim 9, further comprising:
a buffer field plate disposed between the gate dielectric layer and the voltage-blocking layer and located on the upper surface of the semiconductor region, wherein
a thickness of the voltage-blocking layer is greater than a thickness of the buffer field plate, and the thickness of the buffer field plate is greater than a thickness of the gate dielectric layer.

11. The LDMOS transistor according to claim 9, further comprising a drift region of the first doping type located in the semiconductor region, wherein the drift region is located below at least the voltage-blocking layer.

12. The LDMOS transistor according to claim 9, wherein the voltage-blocking layer protrudes toward the interior of the semiconductor region.

13. The LDMOS transistor according to claim 10, wherein a lower surface of the buffer field plate and a lower surface of the gate dielectric layer are located on a same plane parallel to a direction from the source region to the drain region.

14. The LDMOS transistor according to claim 10, wherein a lower surface of the buffer field plate and a lower surface of the gate dielectric layer are higher than a lower surface of the voltage-blocking layer.

15. The LDMOS transistor according to claim 10, wherein the thickness of the gate dielectric layer is set to be in a range of 0.95 nm-9.5 nm.
